# EUROPÄISCHE PATENTSCHRIFT

(11) **EP 0 868 776 B1**
(45) Veröffentlichungstag und Bekanntmachung des Hinweises auf die Patenterteilung: **25.08.1999**
(21) Anmeldenummer: 96946080.7
(22) Anmeldetag: 16.12.1996
(51) Int. Cl.: H03H 9/05

(54) **ELEKTRISCHES BAUELEMENT, INSBESONDERE MIT AKUSTISCHEN OBERFLÄCHENWELLEN ARBEITENDES BAUELEMENT - OFW-BAUELEMENT - SOWIE EIN VERFAHREN ZU DESSEN HERSTELLUNG**
ELECTRICAL COMPONENT, ESPECIALLY ONE OPERATING WITH ACOUSTIC SURFACE WAVES (SW COMPONENT) AND PROCESS FOR ITS PRODUCTION
COMPOSANT ELECTRIQUE, NOTAMMENT COMPOSANT FONCTIONNANT A L'AIDE D'ONDES DE SURFACE ACOUSTIQUES (COMPOSANT A ONDES DE SURFACE), ET SON PROCEDE DE PRODUCTION

(30) Priorität: 21.12.1995 DE 19548062
(43) Veröffentlichungstag der Anmeldung: 07.10.1998
(73) Patentinhaber: SIEMENS MATSUSHITA COMPONENTS GmbH & CO. KG, 81541 München (DE)
(72) Erfinder: PAHL, Wolfgang, D-80336 München (DE); STELZL, Alois, D-81549 München (DE); KRÜGER, Hans, D-81737 München (DE)
(74) Vertreter: Epping, Wilhelm, Dr.-Ing.
(86) Internationale Anmeldenummer: DE9602408
(87) Internationale Veröffentlichungsnummer: WO9723949

(56) Entgegenhaltungen:
- DE-A- 3 138 743
- US-A- 4 293 986

## Beschreibung

Die vorliegende Erfindung betrifft ein elektrisches Bauelement, insbesondere mit akustischen Oberflächenwellen arbeitendes OFW-Bauelement nach dem Oberbegriff des Patentanspruches 1 sowie ein Verfahren zu dessen Herstellung.

In der älteren internationalen Patentanmeldung WO 95/30276 ist eine Verkapselung für elektronische Bauelemente mit einer Bauelementestrukturen auf einem Substrat verschließenden Kappe beschrieben, bei der die Kappe durch eine auf dem Substrat vorgesehene Abdeckung gebildet ist, die in Bereichen der Bauelementestrukturen diese aufnehmende Ausnehmungen besitzt. Eine derartige Verkapselung schützt die Bauelementestrukturen gegen Umwelteinflüsse, so daß derartig verkapselte elektronische Bauelemente gegebenenfalls ohne weiteres Gehäuse unmittelbar weiter verwendbar sind.

Werden derartige Bauelemente in Keramikgehäuse eingebaut und das Gehäuse aus Kostengründen mit Glaslot verschlossen, so ist eine wirksame HF-Abschirmung nicht gegeben, weil dann der Deckel aus Keramik ist bzw. keine leitende Verbindung zum Deckel besteht. Analoges gilt für ein Kunststoffgehäuse.

Vorstehende Nachteile vermeidet das OFW-Filter gemäß DE-A-3 138 743, das in ein allseits dicht geschlossenes metallisches Gehäuse eingeschlossen ist.

Der vorliegenden Erfindung liegt die Aufgabe zugrunde, eine wirksame HP-Abschirmung für elektronische Bauelemente der in Rede stehenden Art anzugeben.

Diese Aufgabe wird bei einem elektronischen Bauelement der eingangs genannten Art erfindungsgemäß durch das Merkmal des kennzeichnenden Teils des Patentanspruchs 1 gelöst.

Ein Verfahren zur Herstellung eines derartigen elektrischen Bauelements ist im Patentanspruch 4 bzw. 5 angegeben.

Weiterbildungen sowohl hinsichtlich des elektronischen Bauelements als auch des Verfahrens zu seiner Herstellung sind Gegenstand entsprechender Unteransprüche.

Die Erfindung wird nachstehend anhand der Ausführungsformen in der Zeichnung näher
erläutert. Es zeigt:
- Fig. 1:: in schematischer Darstellung ein OFW-Bauelement mit einer Abschirmung gemäß der Brfindung;
- Fig. 2:: in schematischer Teildarstellung das Bauelement nach Fig. 1 in Aufsicht;
- Fig. 3:: in schematischer Darstellung und Aufsicht ein SMD-montagegeeignetes OFW-Bauelement mit einer HF-Abschirmung gemäß Erfindung; und
- Fig. 4:: in schematischer Darstellung ein zur Flip-Chip-Montage geeignetes OFW-Bauelement mit erfindungsgemäßer HF-Abschirmung.

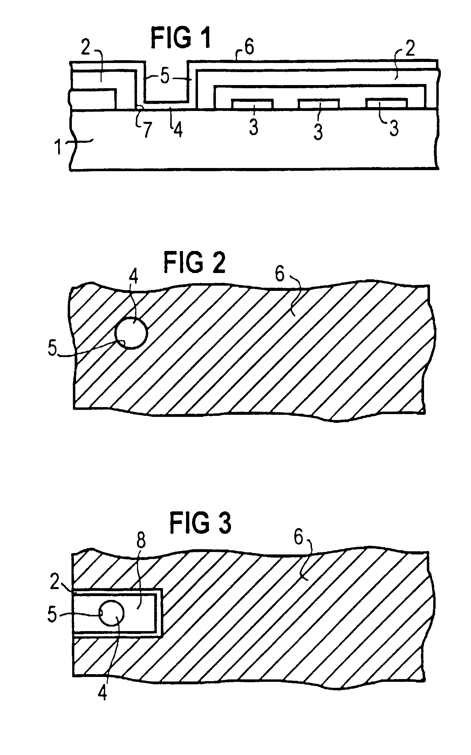

Gemäß Fig. 1 besteht ein OFW-Bauelement grundsätzlich aus einem piezoelektrischen Substrat 1 und darauf vorgesehenen leitenden Strukturen 3, bei denen es sich beispielsweise um Elektrodenfinger von Interdigitalwandlern, Resonatoren oder Reflektoren handeln kann. Wie bereits in der eingangs genannten PCT-Patentanmeldung beschrieben ist sind die elektrisch leitenden Strukturen 3 durch eine Kappe 2 abgedeckt, welche die Strukturen gegen Umwelteinflüsse schützt. Das Bauelement ist mit der Abdeckung 2 und dem Substrat 1 sowohl als "Gehäuse" direkt weiterverwendbar oder in ein Gehäuse einbaubar.

Auf der Kappe 2 ist eine als HF-Abschirmung dienende Metallisierung 6 vorgesehen, die durch eine Materialschichtenfolge TiW, Cu oder Ni und Au gebildet ist und über eine durch ein Fenster 7 in der Kappe 2 durchgreifende Durchkontaktierung 5 mit einer Anschlußfläche 4 - Pad - leitend verbunden ist. Über dieses Pad 4 ist die als HF-Abschirmung dienende Metallisierung 6 mit Masse verbindbar.

Fig. 2 zeigt als Ausschnitt einen Teil des Bauelements nach Fig. 1 mit dem Pad 4 und der Durchkontaktierung 5 sowie der die Oberfläche bedeckenden Metallisierung 6.

Fig. 3 zeigt in Draufsicht eine Ausführungsform eines zur SMD-Montage geeigneten HF-geschirmten Bauelements. Dabei ist auf der Oberfläche der Kappe 2 nach Fig. 1 eine lötfähige Metallisierung 8 vorgesehen, welche über die Durchkontaktierung 5 mit einem Pad 4 leitend verbunden ist. Elektrisch getrennt von dieser lötfähigen Metallisierung 8 ist die der HF-Abschirmung dienende mehrschichtige Metallisierung 6 vorgesehen.

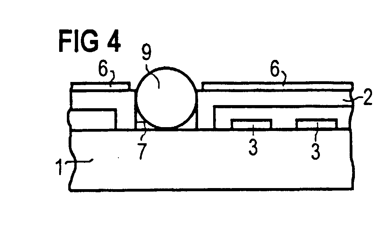

Fig. 4 zeigt in schematischer Darstellung eine mit einer HF-Abschirmung versehene Ausführungsform eines für eine Flip-Chip-Montage geeigneten OFW-Bauelements. Bei dieser Ausführungsform, bei der gleiche Elemente wie bei der Ausführungsform nach Fig. 1 mit gleichen Bezugszeichen versehen sind, ist im Fenster 7 ein Bump 9 vorgesehen, der auf der Substratoberfläche mit einem nicht eigens dargestellten Pad verlötet ist. Ober derartige Bumps 9 kann das Bauelement in einer elektrischen Schaltung montiert werden.

Bei der der HF-Abschirmung dienenden mehrschichtigen Metallisierung 6 gewährleisten die Titan-Wolframschicht die Haftfähigkeit auf der Abdeckung 2, mit Nickelschicht die Lotfähigkeit und die Goldschicht einen Oxidationsschutz. Die Schichtdicken von TitanWolfram sind vorzugsweise kleiner als 0, 1 µm, von Nickel etwa 1 µm und von Gold etwa 0, 1 µm. Die Metallisierung 6 kann derart hergestellt werden, daß auf die Abdeckung 2 zunächst eine dünne metallische Schicht aufgedampft und sodann galvanisch verstärkt wird.

Eine besonders kostengünstige Variante besteht im Aufdampfen einer Schichtfolge aus TiW, Cu oder Ni und Au, deren Dicke insgesamt kleiner als 10µm vorzugsweise gleich 0,3µm ist, der Strukturierung dieser Schicht durch gepulste Ladestrahlung und stromloser Verstärkung mit Cu. Dabei wird auch die Durchkontaktierung 5 erzeugt. Abschließend kann zur Passivierung Au in einer Dicke von 0,5µm abgeschieden werden.

Da die Durchkontaktierungen 5 auf einer eine Vielzahl von Bauelementen enthaltenden Substratscheibe erzeugt werden, können sie auch positioniert sein, daß jeweils ein Teil der Durchkontaktierung jeweils einem Bauelementesystem zugeordnet ist, d.h. eine Durchkontaktierung für zwei Bauelementesysteme ausreicht.

Ebenso kann die Zuverlässigkeit dadurch erhöht werden, daß die Durchkontaktierungen redundant ausgeführt werden, d.h. einem Pad zwei Durchkontaktierungen zugeordnet werden.

## Patentansprüche

1. Elektrisches OFW-Bauelement insbesondere mit akustischen Oberflächenwellen arbeitendes OFW-Bauelement, bei dem auf einem Substrat (1) aufgebrachte, elektrisch leitende Strukturen (3) durch eine kappenförmige Abdeckung (2) dicht gegen Umwelteinflüsse verkapselt sind und das OFW-Bauelement auf der Abdekkung (2) eine Metallisierung (6) als HF-Abschirmung aufweist,
dadurch gekennzeichnet,
daß die Metallisierung (6) durch eine dreischichtige Materialschichtfolge Titan-Wolfram, Kupfer oder Nickel und Gold gebildet ist.

2. Elektrisches Bauelement nach Anspruch 1, dadurch gekennzeichnet, daß Titan-Wolfram oder Kupfer eine Schichtdicke von kleiner 0,1 µm, Nickel eine Schichtdicke von etwa 1 µm und Gold eine Schichtdicke von etwa 0,1 µm besitzen.

3. Elektrisches Bauelement nach Anspruch 1, dadurch gekennzeichnet, daß die Metallisierung (6) durch ein Fenster (7) in der Abdeckung (2) mittels einer Durchkontaktierung (5) elektrisch mit einer Masseanschlußfläche (4) - Pad - verbunden ist.

4. Verfahren zur Herstellung eines OFW-Bauelements nach Anspruch 1 bis 3,
bei dem auf einem Substrat (1) aufgebrachte elektrisch leitende Strukturen (3) durch eine kappenförmige Abdeckung (2) dicht gegen Umwelteinflüsse verkapselt sind und das OFW-Bauelement als HF-Abschirmung auf der Abdeckung (2) eine Metallisierung (6) mit einer dreischichtigen Materialschichtfolge TiW, Cu oder Ni und Au aufweist,
dadurch gekennzeichnet,
daß die Schichtfolgen der Metallisierung (6) zunächst aufgedampft und sodann stromlos oder galvanisch verstärkt werden.

5. Verfahren nach Anspruch 4,
dadurch gekennzeichnet,
daß die Metallisierungen (6) durch Aufdampfen der Schichtfolge TiW, Cu oder Ni und Au, Strukturierung durch gepulste Laserstrahlung und stromlose Verstärkung mit Cu erzeugt werden.

## Claims

1. Electrical SAW component, in particular an SAW component which operates with surface acoustic waves, in which electrically conductive structures (3) which are applied to a substrate (1) are encapsulated by a cover (2) in the form of a cap such that they are sealed against environmental influences, and the cover (2) of the SAW component is metallized (6) to provide RF screening, characterized in that the metallization (6) is formed by a three-layer material layer sequence of titanium-tungsten, copper or nickel and gold.

2. Electrical component according to Claim 1, characterized in that the layer thickness of the titanium-tungsten or copper is less than 0.1 µm, the layer thickness of the nickel is about 1 µm, and the layer thickness of the gold is about 0.1 µm.

3. Electrical component according to Claim 1, characterized in that the metallization (6) is electrically connected to an earth connection surface (4) - pad - through a window (7) in the cover (2), by means of through-plating (5).

4. Method for producing an SAW component according to Claims 1 to 3, in which electrically conductive structures (3) which are applied to a substrate (1) are encapsulated by a cover (2) which is in the form of a cap, such that they are sealed against environmental influences, and the cover (2) of the SAW component is metallized (6), to provide RF screening, with a three-layer material layer sequence of TiW, Cu or Ni and Au, characterized in that the layer sequences of the metallization (6) are initially vapour-deposited and are then reinforced non-electrically or electrochemically.

5. Method according to Claim 4, characterized in that the metallizations (6) are produced by vapour-deposition of a layer sequence of TiW, Cu or Ni and Au, structuring by means of pulsed laser radiation, and non-electrical reinforcement with Cu.

## Revendications

1. Composant OFW électrique, en particulier composant OFW travaillant avec des ondes de surface acoustiques, dans lequel des structures conductrices de l'électricité (3) déposées sur un substrat (1) sont protégées hermétiquement des influences de l'environnement par un recouvrement (2) en forme de capot, et le composant OFW présente sur le recouvrement (2) une métallisation (6) servant de blindage HF, caractérisé en ce que la métallisation (6) est formée par une succession de couches de matière triple couche, titane-tungstène, cuivre ou nickel et or.

2. Composant électrique selon la revendication 1, caractérisé en ce que le titane-tungstène ou le cuivre possède une épaisseur de couche inférieure à 0,1 µm, le nickel une épaisseur de couche d'environ 1 µm et l'or une épaisseur de couche d'environ 0,1 µm.

3. Composant électrique selon la revendication 1, caractérisé en ce que la métallisation (6) est connectée électriquement à une surface de connexion de masse (4) - une pastille - au moyen d'une métallisation traversante (5), à travers une fenêtre (7) ménagée dans le recouvrement (2).

4. Procédé de fabrication d'un composant OFW selon les revendications 1 à 3, dans lequel des structures (3) conductrices de l'électricité déposées sur un substrat (1) sont protégées hermétiquement des influences de l'environnement par un recouvrement (2) en forme de capot, et le composant OFW présente, comme blindage HF sur le recouvrement (2), une métallisation (6) comprenant une succession de couches de matière triple couche TiW, Cu ou Ni et Au, caractérisé
en ce que les successions de couches de la métallisation (6) sont tout d'abord déposées par évaporation et, ensuite, renforcées par un procédé sans électricité ou par galvanoplastie.

5. Procédé selon la revendication 4, caractérisé en ce que les métallisations (6) sont produites par métallisation sous vide de la succession de couches TiW, Cu ou Ni et Au, par structuration par rayonnement laser pulsé et par renforcement avec Cu par un procédé sans électricité.
